# EUROPÄISCHE PATENTSCHRIFT

(11) **EP 1 007 980 B1**
(45) Veröffentlichungstag und Bekanntmachung des Hinweises auf die Patenterteilung: **23.04.2003**
(21) Anmeldenummer: 97912181.1
(22) Anmeldetag: 15.10.1997
(51) Int. Cl.: G01R 1/073, G01R 31/28

(54) **LEITERPLATTENPRÜFVORRICHTUNG**
PRINTED CIRCUIT BOARD TESTING DEVICE
DISPOSITIF POUR TESTER LES CARTES DE CIRCUITS IMPRIMES

(30) Priorität: 03.07.1997 DE 19728427; 16.07.1997 DE 19730516
(43) Veröffentlichungstag der Anmeldung: 14.06.2000
(73) Patentinhaber: Luther & Maelzer GmbH, D-31515 Wunstorf (DE)
(72) Erfinder: DE GRUYTER, Falko, D-31515 Wunstorf (DE); HIGGEN, Hans-Hermann, D-31655 Stadthagen (DE); DEHMEL, Rüdiger, D-31515 Wunstorf (DE)
(74) Vertreter: Schmidt-Evers, Jürgen, Dipl.-Ing.
(86) Internationale Anmeldenummer: EP9705656
(87) Internationale Veröffentlichungsnummer: WO99001772

(56) Entgegenhaltungen:
- EP-A- 0 468 153
- WO-A-89/00296
- WO-A-91/02986
- GB-A- 2 278 965
- US-A- 4 571 542
- ARNETT ET AL.: "SHORTING SHIP" IBM TECHNICAL DISCLOSURE BULLETIN, Bd. 26, Nr. 12, Mai 1984, NEW YORK US, Seiten 6404-6405, XP002039357

## Beschreibung

Die Erfindung betrifft eine Leiterplattenprüfvorrichtung zum elektrischen Prüfen von ultrafeinen Leiterplattenstrukturen nach dem Oberbegriff von Patentanspruch 1.

Üblicherweise werden zur elektrischen Funktionskontrolle von Leiterplatten manuelle, halbautomatische und vollaulomatische Prüfgeräte eingesetzt, deren Aufgabe darin besteht, derartige Leiterplatten, oftmals auch als gedruckte Schaltungen bezeichnet, auf Unterbrechungen und Kurzschlüsse zu überprüfen.

Hierzu können sowohl festverdrahtete Prüfadapter mit Federstiften, sogenannte Universal-Prüfadapter mit starren Prüfstiften oder auch sogenannte fliegende Prüfstift-Systeme mit einzelnen oder mehreren Prüffingern verwendet werden, die computergesteuert auf üblicherweise beiden Seiten einer Leiterplatte auf Prüfflächen aufgesetzt werden und durch Anlegen einer Prüfspannung elektrische Parameter, wie beispielsweise Stromfluß oder Widerstand, abfragen können.

Festverdrahtete Prüfadapter, auch Spezialadapter genannt, in Verbindung mit den entsprechenden Prüfgeräten stellen die ursprünglichste Form von Prüfgeräten dar. Mit solchen Prüfgeräten können auch feine Leiterplattenstrukturen bzw. die feinen Kontaktflächen (sogenannte Pads) diverser IC-Lötflächen kontaktiert werden. Allerdings müssen diese festverdrahteten Prüfadapter produktspezifisch angefertigt werden, verursachen somit hohe Kosten und benötigen entsprechende Anfertigungszeiten.

Durch Verwendung sogenannter Universal-Prüfadapter kann die Anfertigungszeit und können die Anfertigungskosten gegenüber den oben genannten Spezialadaptern reduziert werden. Allerdings sind die Investitionskosten derartiger Prüfgeräte höher als für festverdrahtete Prüfadapter, da hier die Prüfelektronik matrixförmig mit beispielsweise 2,54 mm (100 mil = 0,1 inch), 1,78 mm (70 mil) oder nur 1,27 mm (50 mil) Rasterabstand der Kontaktflächen für die Prüfstifte zur Verfügung stehen muß und nicht, wie bei den festverdrahteten Prüfadaptern, lediglich entsprechend der Anzahl der erforderlichen Prüfpositionen.

Bei Prüfgeräten mit sogenannten fliegenden Prüffingern ist demgegenüber kein Prüfadapter erforderlich. Allerdings wird bei diesen Prüfgeräten ein entsprechend optimiertes Softwareprogramm zur Ansteuerung aller Prüfpositionen benötigt und es müssen die entsprechenden elektrischen Signale ausgewertet werden. Als Vorteil solcher Prüfgeräte ist der Wegfall der Kosten für Prüfadapter und der theoretisch extrem kleine mögliche Prüfpunktabstand zu sehen. Nachteilhaft ist bei diesem System dahingegen die niedrigere mögliche Prüfgeschwindigkeit, die einen Einsatz bei größeren Leiterplatten mit entsprechend höherer Anzahl an Prüfpunkten und bei höheren Stückzahlen aus Zeit- und Kostengründen nicht zuläßt.

Durch die immer höher werdende Integration von elektrischen Bauelementen durch Technologien, wie beispielsweise COB (Chip on Board), und durch den Einsatz von Flip-Chip und MCM (Multi Chip Modul) - Technologien werden die Strukturen auf den Leiterplatten immer feiner und die Dichte der mit den Prüfstiften zu kontaktierenden Prüfflächen wird immer größer.

Derartige Leiterplatten können zwar noch mit den sogenannten fliegenden Prüffinger-Prüfgeräten geprüft werden, allerdings können damit, wie oben bereits erwähnt, keine Massenprodukte wirtschaftlich und mit akzeptablen Prüfzeiten getestet werden.

Mit festverdrahteten Adaptersystemen und mit Universal-Adaptersystemen wird hingegen beispielsweise die Messung von IC-Geometrien mit 100 µm (4 mil) Löt- bzw. Bondflächen und damit 200 µm (8 mil) Rastermaß nahezu unmöglich. Bei derartigen Systemen müssen Prüfspitzen mit typisch bis zu 0,25 mm Durchmesser oder sogar auch nur 0,12 mm Durchmesser verwendet werden, und diese müssen gesichert bei mehreren 100 Meßzyklen pro Stunde Kontaktflächen von bis zu 0,10 mm Breite in einem Rastermaß von beispielsweise 0,20 mm treffen.

Um die Trefferquote zu erhöhen, sind zwar optoelektronische Justierhilfen und ferner sogenannte Microadjustment-Systeme bekannt, die bei Feststellung von hoher Fehlerzahl der Leiterplatte eine sehr kleine Auslenkung der Prüfposition verursachen und einen weiteren Prüfvorgang auslösen. Dieser Vorgang wird mehrfach wiederholt bis Fehlerfreiheit oder die voreingestellte Anzahl von Meßzyklen erreicht und in diesem Fall die Leiterplatte als fehlerhaft ausgeworfen wird. Der Nachteil dieses Systems liegt in der längeren Meßzeit und vor allem in der höheren Anzahl an Prüfspitzenabdrücken auf den Leiterplatten bzw. den Kontaktflächen.

Diese Prüfspitzenabdrücke sind wiederum für eine immer häufiger werdende Leiterplattenausführung, für sogenannte COB (Chip on Board) - Montagen nicht mehr akzeptierbar, da beim sogenannten Bonden der Chips derartige Abdrücke zu einer Erhöhung der Fehlerquote führen. Üblicherweise sind solche Kontaktflächen für Bonddrahtkontaktierungen vergoldet. Dieses Problem der Nicht-Akzeptanz von Prüfsspitzenabdrücken trifft jedoch auch auf chemisch-Zinn-Oberflächen und auf eine Reihe weiterer neuartiger ultrafeiner Leiterplattenstruktur-Technologien zu.

Neuartige Prüfmethoden verwenden zur Vermeidung von Prüfspitzenabdrücken deshalb beispielsweise anisotrope dünne Gummimatten, die unter Druck leitend werdens, US-A-4 571 542. Diese Methode wurde beispielsweise von der Firma Japan Synthetic Rubber Co., LTD. (JSR), Tokio, Japan entwickelt. Dabei werden allerdings sogenannte Translator-Leiterplatten benötigt, die auf der zu prüfenden Leiterplattenseite die im allgemeinen spiegelbildlich angeordneten erhobenen Kontaktflächen aufweisen. Dazwischen wird eine dünne Gummimatte von wenigen 0,10 mm Dicke, beispielsweise 0,2 mm, eingefügt, die durch selektiven Druck im Bereich der Kontaktflächen leitend wird und in den danebenliegenden Zwischenräumen isolierend bleibt. Auf der Rückseite der sogenannten Translator-Leiterplatten können nun entsprechende Prüfstifte zur Beaufschlagung der Prüfspannungen angebracht sein oder es können auch matrix-förmig angeordnete Prüfflächen mit beispielsweise 2,54 mm (100 mil), 1,78 mm (70 mil), 1,27 mm (50 mil) oder ähnlichem Rastermaß angeordnet sein, die wiederum mittels weiterer elastomerer leitfähiger Matten verbunden werden. Diese druckempfindlichen und leitfähigen Matten werden üblicherweise mit korrespondierenden leitfähigen Matrixstrukturen verwendet und weisen eine größere Dicke von beispielsweise 1,0 mm (70 mil - Raster) bzw. 1,6 mm (100 mil-Raster) auf. Sie dienen damit gleichzeitig als Federelement zum Ausgleichen kleiner Unebenheiten auf der zu prüfenden Leiterplatte und auf der Translator-Leiterplatte und sollen zu einer gleichmäßigen Druckbeaufschlagung rühren.

Neben der Anwendung der obigen anisotropen leitfähigen Gummimatten-Technologie werden zur Vermeidung von Prüfspitzenabdrücken auf ultrafeinen Leiterplattenstrukturen von typischerweise 0,25 mm (10 mil) bis 0,20 mm (8 mil) und auch bereits darunter liegenden Rastermaßen, also Kontaktflächen von weniger als 100 µm (4 mil) und entsprechend geringen Abständen von weniger als 100 µm (4 mil), vermehrt kontaktlose Sensoren in den Prüfgeräten eingesetzt. Damit können sowohl die Anforderungen der Beschädigungsfreiheit als auch die Anforderungen hinsichtlich Funktionskontrolle der ultrafeinen Strukturen erfüllt werden. Allerdings funktionieren derartige Sensoren im allgemeinen auf kapazitiver Basis, und es werden Transienten von Spannungsimpulsen gemessen, die über Prüfspitzen auf entsprechend größere Kontaktflächen eingebracht werden, und im Falle einer elektrischen Verbindung zu einer der korrespondierenden feinen Kontaktflächen im Bereich der kontaktlosen Sensoren wird ein Signal empfangen oder es wird kein Signal empfangen. Damit können in gewisser Weise und bei Verwendung entsprechender Softwareprogramme Kurzschlüsse und Unterbrechungen auf der Leiterplatte festgestellt werden. Allerdings fließt bei dem Prüfvorgang kein Strom. sondern es werden lediglich Transienten delektiert.

Derartige Transienten-Sensoren erfordern ganz spezielle Prüfgeräte und Prüfelektroniken, die auf die geringen elektrischen Kapazitäten reagieren. Der Einsatz derartiger Sensoren ist bei fesrverdrahteten Prüfadadapter-Systemen und auch bei den fliegenden Prüffinger-Systemen eine Möglichkeit, die elektrische Prüfung von ultrafeinen Leiterplattenstrukturen ohne Beschädigung der Kontaktflächen durchzuführen. Der Einsatz bei Universaladapter-Systemen erscheint aufgrund der doch sehr kleinen zu messenden Kapazitätswerte nicht erfolgversprechend.

Ausgehend von dem oben genannten Stand der Technik ist es eine Aufgabe der vorliegenden Erfindung, eine Leiterplattenprüfvorrichtung so auszubilden, daß die oben beschriebenen Mängel beim Stand der Technik beseitigt werden und die Vorrichtung für die elektrische Prüfung ultrafeiner Leiterplattenstrukturen ohne Beschädigung der zu prüfenden Kontaktflächen und Leiterbahnen geeignet ist.

Diese Aufgabe wird durch die Merkmale des Anspruches 1 gelöst.

Bei der erfindungsgemäßen Vorrichtung ist ein zwischen wenigstens einen Prüfstift und die Leiterplatte einführbares Kontaktelement vorgesehen, dessen der Leiterplatte zugewandte Seite Abmessungen derart hat, dass das Kontaktelement zur gleichzeitigen Kontaktierung von mindestens zwei Leiterbahnen oder Kontaktflächen geeignet ist, wobei das Kontaktelement zwischen einem Durchlassmodus und einem Sperrenmodus umschaltbar ist, und wobei es im Durchlassmodus einen Stromfluss zwischen den entsprechenden Prüfstift (e,n) und den kontaktierten Leiterbahnen oder Kontaktflächen zulässt und dem Sperrmodus einen solchen Stromfluss unterbindet und zusätzlich die kontaktierten Leiterbahnen oder Kontaktflächen voneinander isoliert.

Das erfindungsgemäße Kontaktelement bildet im Prinzip einen Prüfsensor mit Diodenwirkung. Die Konstruktion des Kontaktelementes ist so gewählt, daß es im Sperrmodus einen Stromfluß sowohl zwischen dem (den) Prüftsrift(en) und den überdeckten Leiterbahnen bzw. Kontakrflächen unterbindet, als auch einen Stromfluß zwischen den überdeckten Leiterbahnen bzw. Kontaktflächen selbst. Im Durchlaßmodus sorgt das Kontaktelement dagegen dafür, daß zwischen dem (den) Prüfstift(en) und den überdeckten Leiterbahnen bzw. Kontaktflächen ein Prüfstrom fließen kann, wenn die überdeckten Leiterbahnen bzw. Kontaktflächen auf einem entsprechenden Potential liegen.

Bei der Prüfung einer Leiterplatte mit einem solchen Kontaktelement wird davon Gebrauch gemacht, daß jede von dem Kontaktelement überdeckte Leiterbahn bzw. Kontaktfläche mit einer nicht überdeckten Leiterbahn bzw. Kontaktfläche auf der Leiterplatte in Verbindung steht, wo ein weiterer Prüfstift aufsetzen kann. Auf diese Weise können gleichzeitig mehrere eng beieinander liegende Leiterbahnen bzw. Kontaktflächen über das Kontaktelement mit einem einzigen Prüfstift erfasst werden. Wollte man derartige eng beieinander liegende Leiterbahnen bzw. Kontaktflächen jeweils mit einem separaten Prüfstift erfassen, so würde nicht nur der entsprechende Adapter höchst kompliziert und wegen der notwendigerweise dünnen Prüfstifte anfällig gegen Fehlfunktionen sein, sondern auch die Prüfmoduln müssten eine äußerst hohe Konzentration an Bauelementen (Zahl pro Raumeinheit) haben, wodurch sie unwirtschaftlich teuer werden würden.

Ein besonderer Vorteil der Erfindung besteht ferner darin, daß das Kontaktelement mit nur geringem Kosten- und Arbeitsaufwand in bereits bestehende Prüfanlagen-Systeme integrierbar ist, wobei ein Einsatz des Kontaktelementes sowohl in festverdrahteten Spezialadaptern, Universaladaptern als auch in fliegenden Prüffinger-Systemen möglich ist.

Gemäß den Merkmalen des Unteranspruchs 3 ist das Kontaktelement in Form einer sogenannten Schottky-Diode mit einem Metall-Halbleiter-Übergang realisiert, der eine klare Sperr- und Durchlaßfunktion mit schnellen Schaltzeiten gewährleistet. Die halbleitende Beschichtung des Kontaktelementes wird durch eine Vorspannung in einen hochohmigen Zustand versetzt werden, der nur selektiv bei Anlegen einer Prüfspannung an eine der Leiterbahnen bzw. Kontaktflächen in einen leitenden Zustand verändert wird, so daß ein Stromfluß bewirkt wird, der in der Auswerteschaltung des Prüfgerätes ausgewertet werden kann.

In einer Weiterbildung der Erfindung ist die der Leiterplatte zugewandte Seite des Kontaktelementes nicht vollflächig mit einer halbleitenden Beschichtung versehen, sondern weist matrixförmig oder streifenförmig angeordnete Flächenelemente aus einem halbleitenden Material auf, wobei die zwischen diesen halbleitenden Flächenelementen liegenden Bereiche isolierend ausgeführt sind. Durch diese Maßnahme wird einerseits der Vorteil des gemeinsamen elektrischen Anschlusses des Kontaktelementes an der den Prüfstiften zugewandten Seite genutzt und andererseits eine verbesserte Sperrwirkung zwischen den einzelnen nebeneinanderliegenden Leiterbahnen bzw. Kontaktflächen der ultrafeinen Leiterplattenstruktur erreicht.

Vorteilhafterweise ist auf die der Leiterplatte zugewandten Seite des Kontaktelementes ein druckleitendes Ausgleichselement aufgebracht, welches elastisch und selektiv unter Druckeinwirkung elektrisch leitend und ohne Druckeinwirkung isolierend ist. Hierdurch können Unebenheiten in der zu prüfenden Leiterplattenstruktur ausgeglichen und alle Kontaktflächen unterhalb des Kontaktelementes sicher kontaktiert werden.

Weitere Ausgestaltungen und Weiterbildungen der vorliegenden Erfindung sind Gegenstand weiterer Unteransprüche.

Bevorzugte Ausführungsbeispiele der Erfindung werden im folgenden anhand der beiliegenden Zeichnung näher erläutert. Darin zeigen:
- Figur 1: eine schematische Darstellung eines Ausschnitts einer üblichen Leiterplatte mit einer zumindest teilweise ultrafeinen Leiterplattenstruktur;
- Figur 2: eine schematische Darstellung zur Erklärung des Aufbaus und der Funktionsweise der erfindungsgemäßen Vorrichtung;
- Figur 3: eine schematische Darstellung zur Erklärung des Aufbaus und der Funktionsweise der erfindungsgemäßen Vorrichtung;
- Figur 4: eine schematische Darstellung zur Erklärung der Anwendungsmöglichkeit der erfindungsgemäßen Vorrichtung in Spezial- und Universal-Prüfadaptern;
- Figur 5: eine ausschnittweise Vergrößerung von Figur 4;
- Figur 6: eine schematische Darstellung zur Erklärung der Anwendungsmöglichkeit der erfindungsgemäßen Vorrichtung in fliegenden Prüffinger-Systemen;
- Figur 7: ein Ausführungsbeispiel eines erfindungsgemäßen Kontaktelementes mit einem Führungselement in schematischer perspektivischer Darstellung;
- Figur 8: ein weiteres Ausführungsbeispiel eines erfindungsgemäßen Kontaktelementes im Schnitt entlang seiner Längsachse;
- Figur 9: das Kontaktelement von Figur 8 im Schnitt entlang Linie IX-IX von Figur 8;
- Figur 10: ein weiteres Ausführungsbeispiel eines erfindungsgemäßen Kontaktelementes im Schnitt analog der Ansicht von Figur 9;
- Figur 11: ein weiteres Ausführungsbeispiel eines erfindungsgemäßen Kontaktelementes im Schnitt analog der Ansicht von Figur 9; und
- Figur 12: eine schematische Darstellung einer mit der erfindungsgemäßen Vorrichtung prüfbaren ultrafeinen Leiterplattenstruktur.

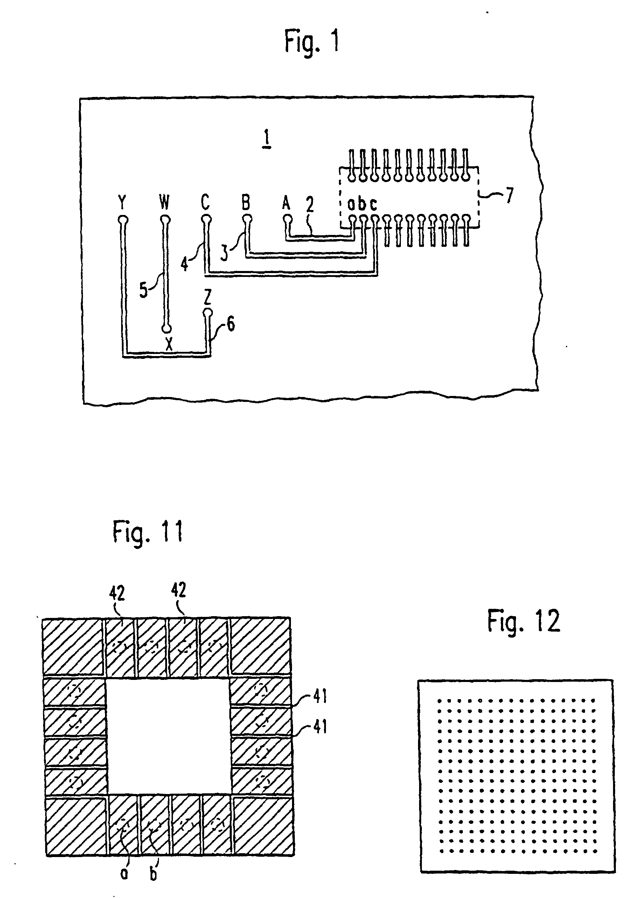

Anhand der Figuren 1 bis 3 soll zunächst das Grundprinzip der erfindungsgemäßen Leiterplattenprüfvorrichtung näher erläutert werden. Im Anschluß daran werden verschiedene bevorzugte Ausführungsformen und Anwendungsmöglichkeiten der Erfindung dargestellt.

Figur 1 zeigt in schematischer Darstellung ausschnittweise eine in der Praxis übliche Leiterplatte 1 mit mehreren Leiterbahnen 2-6 und mehreren Kontaktflächen A, B, C, .... W, X, Y, Z einer normalen Leiterplattenstruktur und mehrere Kontaktflächen a, b, c, ... einer ultrafeinen Leiterplattenstruktur, wie sie beispielsweise für IC-Bausteine und dergleichen benötigt werden. Die Kontaktflächen a, b, c, ... der ultrafeinen Struktur sind üblicherweise über Leiterbahnen 2-4 mit anderen Kontaktflächen A, B, C, ... auf der Leiterplatte verbunden. Mit dem Bezugszeichen 7 ist ein gestrichelt markierter Bereich für die mögliche Anwendung eines erfindungsgemäßen Kontaktelementes bezeichnet, der sämtliche für den IC-Baustein vorgesehenen Kontaktflächen a, b, c, ... der ultrafeinen Leiterplattenstruktur abdeckt.

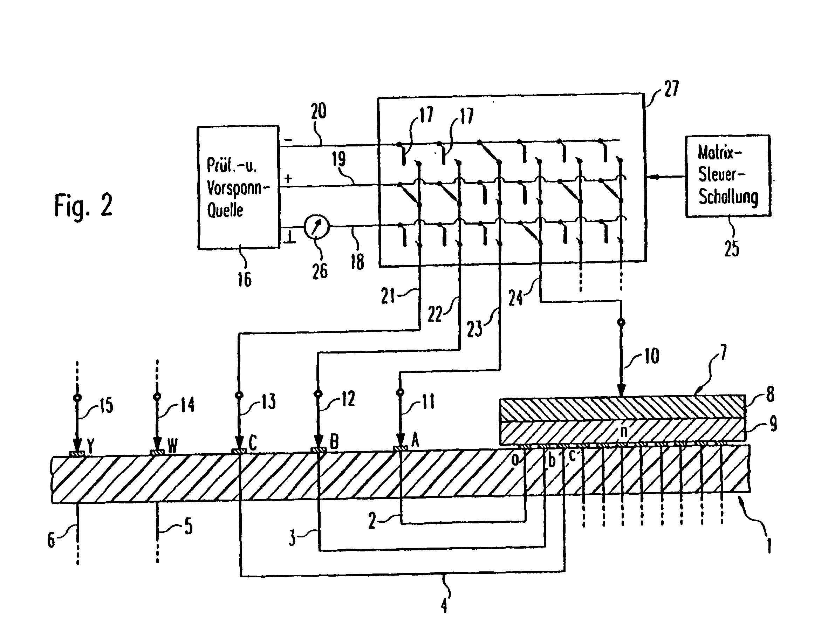

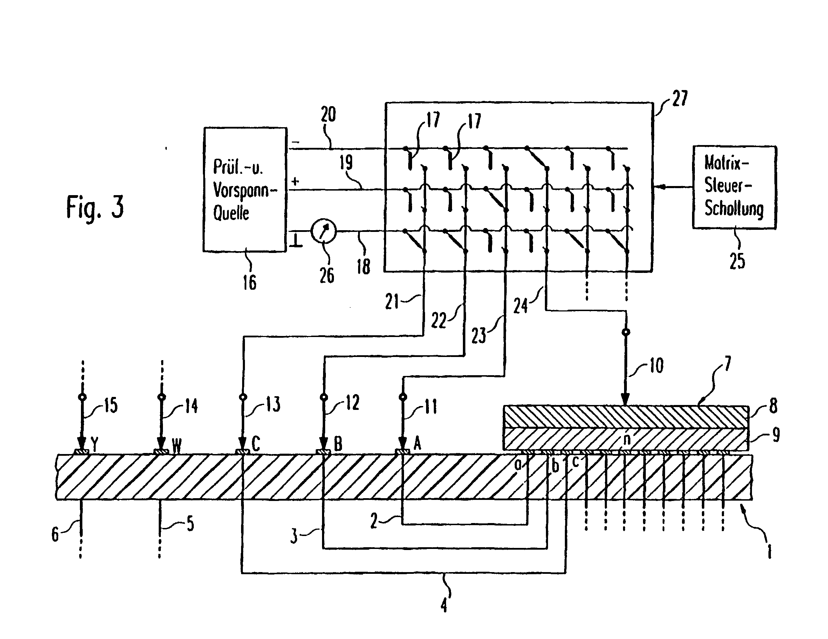

In den Figuren 2 und 3 ist schematisch der Aufbau der Vorrichtung dargestellt, wobei die Leiterplatte 1 mit Leiterbahnen und Kontaktflächen aus Figur 1 im Schnitt gezeigt ist. Die Leiterplattenprüfvorrichtung enthält, wie auch die oben beschriebenen herkömmlichen Prüfgeräte, mehrere Prüfstifte 10-15 zum Kontaktieren der Leiterbahnen 2-6 bzw. der mit diesen verbundenen Kontaktflächen a, b, c, ... oder A, B, C, ..., W, X, Y, Z. Die Prüfstifte 10-15 sind mittels Leitungsverbindungen 21-24 über eine Matrixschaltung 27 mit einer Prüfimpulse erzeugenden Prüfspannungsquelle 16 verbunden, die gleichzeitig als Vorspannungsimpulse erzeugende Vorspannungsquelle dient. Die Prüf- und Vorspannungsquelle 16 hat einen Ausgang 20, an dem negative Vorspannungsimpulse ausgegeben werden, einen Ausgang 19, an dem positive Prüfimpulse ausgegeben werden und einen Masse-Ausgang 18. Die Matrixschaltung 27 verbindet die Verbindungsleitung 21-24 eines jeden Prüfstiftes 10-15 matrixförmig über Schaltelemente 17 wahlweise mit jedem Ausgang 18-20 der Prüf- und Vorspannungsquelle 16. Die Steuerung der Schaltelemente 17 der Matrixschaltung 27 erfolgt über eine Matrix-Steuerschaltung 25. Zwischen der Matrixschaltung 27 und dem Masse-Ausgang 18 der Prüf- und Vorspannungsquelle 16 ist eine Auswerteschaltung 26 in Form eines bekannten Strommeßgerätes geschaltet.

Zwischen die Kontaktflächen a, b, c, ... einer ultrafeinen Leiterplattenstruktur, beispielsweise eines IC-Bausteins, und den diesen gegenüberliegenden Prüfstift 10 wird ein Kontaktelement 7 positioniert. Anstelle des einen Prüfstiftes 10 können auch mehrere Prüfstifte 10 mit dem Kontaktelement 7 verbunden und in der Matrixschaltung 27 entsprechend parallel geschaltet sein.

Das Kontaktelement 7 besteht auf seiner dem (den) Prüfstift(en) 10 zugewandten Seite aus einem Substrat 8 aus einem elektrisch leitendem Material, das mit mindestens einem der Prüfstifte 10 eine elektrische Kontaktverbindung bildet. Vorzugsweise besteht das Substrat 8 aus einer Metallschicht bzw. -folie, und insbesondere aus Messing, Nirosta, Wolfram oder einer Oberflächen-vergoldeten Metallfolie. Das Substrat sollte gut elektrisch leitend sein und keine isolierende Oberflächenoxidation aufweisen.

Das Substrat 8 ist auf seiner der Leiterplatte 1 zugewandten Seite mit einer halbleitenden Beschichtung 9 versehen. Die Beschichtung 9 ist so groß bemessen, daß sie mehrere Kontaktflächen a, b, c, ... einer ultrafeinen Leiterplattenstruktur überdecken und somit gleichzeitig kontaktieren kann. Die Funktion dieser Beschichtung 9 bzw. dieses Kontaktelementes 7 wird aus der folgenden Beschreibung der Figuren 2 und 3 besser ersichtlich.

Die Prüfung der Leiterbahnen 5 und 6 bzw. der mit diesen verbundenen Kontatflächen W, X, Y und Z. die bezüglich ihrer Dichte auf der Leiterplatte eine normale Leiterplattenstruktur aufweisen, soll hier nicht näher erklärt werden. Es wird an dieser Stelle der Einfachheit halber auf entsprechende Druckschriften über elektrische Prüfgeräte für Leiterplatten aus dem Stand der Technik verwiesen, da die Leiterplattenprüfvorrichtung diesbezüglich keinen Unterschied aufweist.

Anhand von Figur 2 wird zunächst beispielhaft die Prüfung von Leiterbahn 2 auf Unterbrechung erläutert. Die Leiterbahn 2 verbindet, wie insbesondere in Figur 1 veranschaulicht, die Kontaktfläche a eines IC-Bausteins mit der Kontaktfläche A einer entsprechenden Verbindungsstelle des IC-Bausteins auf der Leiterplatte 1. Zur Prüfung der Leiterbahn 2 steuert die Matrix-Steuerschaltung 25 die Schaltelemente 17 der Matrixschaltung 27 derart, daß der Prüfstift 10 über seine Verbindungsleitung 24 mit dem Masse-Ausgang 18 und der Prüfstift 11 über seine Verbindungsleitung 23 mit dem Ausgang 20 für negative Spannungsimpulse verbunden ist. Sämtliche anderen Prüfstifte 12-13, die eine Kontaktfläche B, C, ... kontaktieren, die mit einer entsprechenden anderen überdeckten Kontaktfläche b, c, ... in Verbindung stehen, sind über deren Verbindungsleitungen 21-22 mit dem Ausgang 19 für positive Spannungsimpulse der Prüf- und Vorspannungsquelle 16 verbunden sind, während die Prüfstifte 14-15, die eine Kontaktfläche W, X, ... kontaktieren, die mit keiner der überdeckten Kontaktflächen a, b, c, ... in Verbindung steht, im allgemeinen nicht mit der Prüf- und Vorspannungsquelle 16 verbunden sind.

Somit liegt an dem leitenden Substrat 8 des Kontaktelementes 7 Masse und an der n-dotierten Halbleiterbeschichtung 9 des Kontaktelementes 7 ein demgegenüber negativeres Potential im Bereich der Kontaktfläche a und ein demgegenüber positiveres Potential im Bereich der anderen überdeckten Kontaktflächen b, c, ... an. Hierdurch wird das Kontaktelement 7, das im Prinzip wie eine Schottky-Diode aufgebaut ist, aufgrund der sogenannten Majoritätsträgerdiffusion im Bereich über der überdeckten Kontaktfläche a leitend und aufgrund der Potentialdifferenz zwischen dem Prüfstift 11 an der Kontaktfläche A und dem Prüfstift 10 an dem Kontaktelement 7 fließt - bei ordnungsgemäßer Leitungsbahn 2 - zwischen den beiden Prüfstiften 10 und 11 ein Impulsstrom, der durch das Strommeßgerät 26 erfasst wird und ausgewertet werden kann. Im Bereich über den anderen überdeckten Kontaktflächen b, c. ... befindet sich das Kontaktelement 7 hingegen im Sperrmodus, so daß hier kein Strom zwischen den Prüfstiften 12-13 an den Kontaktflächen B. C und dem Prüfstift 10 an dem Kontaktelement 7 fließen kann.

Anhand von Figur 3 wird nun beispielhaft die Prüfung auf Isolation zwischen der Leiterbahn 2 bzw. der Kontaktfläche a und einer der anderen Leiterbahnen 3-6 bzw. einer der anderen Kontaktflächen b, c, ..., B, C, ..., W, X, Y, Z auf der Leiterplatte 1 erläutert. Durch diese Prüfung soll zunächst nur eine fehlerhafte Leiterplatte 1 erkannt und aussortiert werden, eine genauere Spezifizierung des Fehlers bzw. der Fehlerstelle auf der Leiterplatte 1 ist an dieser Stelle zunächst nicht nötig oder erwünscht und kann später erfolgen.

Zur Prüfung der Isolation von Leiterbahn 2 steuert die Matrix-Steuerschaltung 25 die Schaltelemente 17 der Matrixschaltung 27 derart, daß der Prüfstift 10 über seine Verbindungsleitung 24 mit dem negativen Ausgang 20 für negative Sperrimpulse verbunden ist, der Prüfstift 11 über seine Verbindungsleitung 23 mit dem Ausgang 19 für positive Prüfimpulse verbunden ist, und sämtliche anderen Prüfstifte 12-13, die eine Kontaktfläche B, C, ... kontaktieren, die mit einer entsprechenden anderen überdeckten Kontaktfläche b, c, ... in Verbindung stehen, über deren Verbindungsleitungen 21-22 mit dem Masse-Ausgang 18 der Prüf- und Vorspannungsquelle 16 verbunden sind. Somit liegt an dem leitenden Substrat 8 des Kontaktelementes 8 ein negatives Impulspotential und an der n-dotierten Halbleiterbeschichtung 8 des Kontaktelementes 7 ein demgegenüber positiveres Potential, nämlich ein positives Impulspotential an der Kontaktfläche a und Masse an den anderen Kontaktflächen b, c, ..., an. Hierdurch sperrt das Kontaktelement 7 gemäß dem Prinzip einer Schottky-Diode und die Halbleiterbeschichtung 9 isoliert die Kontaktflächen a, b, c, ... der ultrafeinen Leiterplattenstruktur gegeneinander. Falls die Leitungsbahn 2 oder eine der mit ihr in Verbindung stehenden Kontaktflächen a, A irgendeine andere Leitungsbahn 3-6 oder irgendeine andere Kontaktfläche b, c, ..., B, C, ..., W, X, Y, Z kontaktiert, so fließt aufgrund der Potentialdifferenz zwischen dem Prüfstift 11 an der Kontaktfläche A und den Prüfstiften 12-15 an den entsprechenden Kontaktflächen B, C, ..., W, X, Y, Z zwischen diesen ein Impulsstrom, der durch das Strommeßgerät 26 erfasst wird und ausgewertet werden kann.

Wie oben beschrieben weist das Kontaktelement 7 eine Diodenfunktion mit einem Durchlaßmodus und einem Sperrmodus auf, der für die Prüfung der ultrafeinen Leiterplattenstruktur ausgenutzt werden kann. Der wesentliche Vorteil des Kontaktelementes 7 liegt darin, daß es einerseits einen gemeinsamen elektrischen Anschluß 8 hat und andererseits auf der den Kontaktflächen a, b, c, ... auf der Leiterplatte 1 zugewandten Seite 9 eine Diodenfunktion aufweist, wobei sowohl der Diodeneffekt zwischen den diversen Kontaktflächen und dem Prüfstift als auch der Diodeneffekt zwischen den einzelnen Kontaktflächen untereinander ausgenutzt wird, so daß trotz Kontaktierung mehrerer nebeneinanderliegender Kontaktflächen diese nicht kurzgeschlossen werden. Die halbleitende Beschichtung des Kontaktelementes kann durch eine Impuls-Vorspannung in einen hochohmigen Zustand versetzt werden, der nur selektiv bei Anlegen einer Prüfspannung an eine der Kontaktflächen in einen leitenden Zustand verändert wird, so daß ein Stromfluß bewirkt wird, der in einer Auswerteschaltung des Prüfgerätes ausgewertet werden kann.

In den Figuren 2 und 3 ist das Kontaktelement 7 beispielhaft in Form einer sogenannten Schottky-Diode mit einem Metall-Halbleiter-Übergang dargestellt, wobei die Halbleiterbeschichtung 9 n-dotiert ist. Ein solcher Schottky-Übergang ist besonders vorteilhaft, da er eine klare Sperr- und Durchlaßfunktion mit schnellen Schaltzeiten gewährleistet.

Es bieten sich allerdings auch komplexere Schichtaufbauten mit hoher Sperr- und Durchlaßfunktion auf Basis der diversen Elementhalbleitermaterialien, wie C, Si, Ge, Sn, bzw. allgemein auf Basis der Elemente der IV. Gruppe des Periodensystems mit jeweils vier Valenzelektronen an. Ferner sind auch Schichtaufbauten auf der Basis von Verbindungshalbleitern, wie beispielsweise GaAs, ZnS, ZnSe, ZnTe, CdTe, HgSe, AlAs, AlSb, GaP, InP, InAs, InSb. Bl₂Te₃, PbTe, PbS, etc. möglich.

Von der Prüfspannungsquelle 16 werden Meßspannungen und -ströme in Form von Prüfimpulsen der in den Figuren 2 und 3 angedeuteten Polarität von 5 bis 20 Volt erzeugt, die zu einem typischen Stromfluß von 1 bis 10 mA führen. Die Schaltfrequenz, mit der die Matrix-Steuerschaltung 25 die Schaltermatrix 27 umschaltet, liegt im kHz-Bereich, typischerweise bei 10 kHz.

Es ist nicht zwingend erforderlich, daß die Prüf- und Vorspannungsquelle 16 am Ausgang 20 negative Sperrimpuise und am Ausgang 19 positive Prüfimpulse ausgibt. Zumindest theoretisch funktioniert das System auch, wenn am Ausgang 20 eine negative Gleichspannung und am Ausgang 19 eine positive Gleichspannung ausgegeben wird. Die Verwendung von Spannungsimpulsen hat den Vorteil, daß die Umschaltung der von Halbleiterelementen gebildeten Schalter 17 in der Schaltermatrix 27 in einer Umschaltphase erfolgen kann, in der kein Prüfstrom fließt. Dadurch werden nicht nur die Schalter 17 nicht belastet, sondern auch die Prüfung genauer.

Als bevorzugte Ausführungsform wird als Prüf- und Vorspannungsquelle 16 eine Prüf- und Vorspannungsquelle von bekannten und in der Praxis vorhandenen Universal- und Dedicated-Leiterplattenprüfsystemen verwendet. In diesem Fall können die dort vorhandenen Potentiale Signal (+), offen (floatened) und Masse (-) verwendet und damit die Schaltmatrix 27 benutzt werden.

Die Breite eines Kontaktelementes 7 beträgt beispielsweise 1,0 bis 2,0 mm und die Dicke beispielsweise 0,1 bis 1,0 mm. Die Kantenlänge des Kontaktelementes 7 ist je nach Größe der ultrafeinen Leiterplattenstruktur, d.h. beispielsweise nach Länge des IC-Bausteins, frei wählbar.

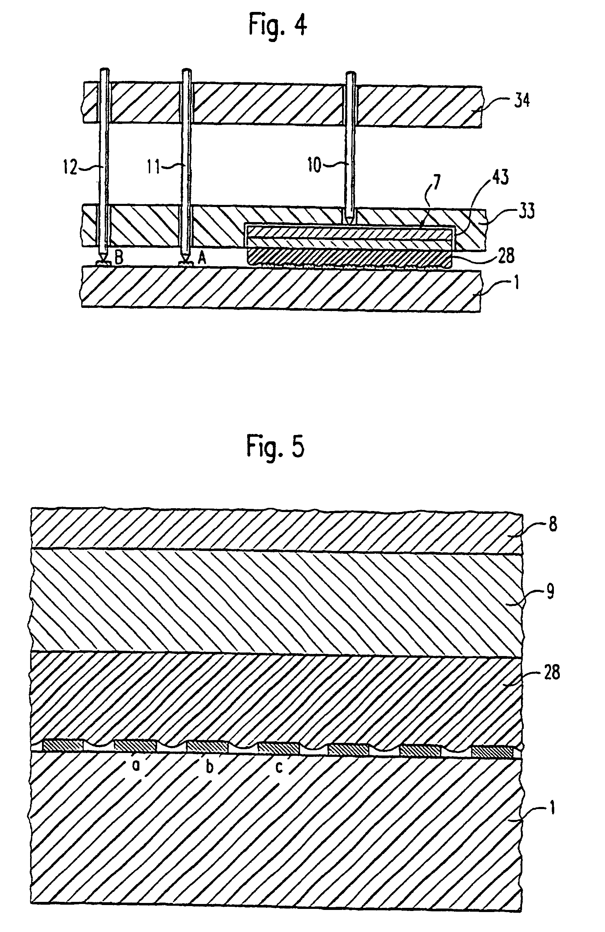

Wie bereits oben erwähnt, können die Kontaktelemente 7 gemäß der vorliegenden Erfindung in allen gängigen Prüfsystemen ohne großen Kosten- und Arbeitsaufwand eingesetzt werden. Figur 4 zeigt schematisch die Anwendung in einem Mehrplatten- bzw. Universal-Prüfadapter, wobei hier nur die beiden der Leiterplatte 1 nächstliegenden Führungsplatten 33 und 34 dargestellt sind. Aufbau und Funktionsweise eines solchen Mehrplatten-Prüfadapters sind beispielsweise in der Patentschrift DE-C2-34 44 708 der Anmelderin genauer beschrieben, weshalb hier der Einfachheit halber nur auf diese Druckschrift Bezug genommen wird.

Die der Leiterplatte 1 nächstliegendste Führungsplatte 33 des Mehrplatten-Adapters weist an ihrer der Leiterplatte 1 zugewandten Seite eine Ausnehmung 43 auf, in die das Kontaktelement 7 eingesetzt werden kann. Eine solche Ausnehmung 43 ist von Vorteil, um das Kontaktelement 7 sicher mit dem Prüfadapter verbinden und genau positionieren zu können. Wie in Figur 4 gezeigt, muß der bzw. müssen die mit dem Kontaktelement 7 verbundene(n) Prüfstift(e) 10 entsprechend kürzer ausgebildet werden als die übrigen Prüfstifte 11-15 des Prüfadapters.

Bei der Verwendung eines Spezialadapters mit festverdrahteten Prüfstiften 10-15 ist der Aufbau analog dem in Figur 4 gezeigten. Der Unterschied besteht darin, daß der Spezialadapter sozusagen nur aus einer Führungsplatte 33 besteht, die mit einer entsprechenden Ausnehmung 43 für das Kontaktelement 7 versehen ist.

An der der Leiterplatte 1 zugewandten halbleitenden Beschichtung 9 des Kontaktelementes 7 ist ein druckleitendes Ausgleichselement 28 angebracht, dessen Grundform derjenigen des Kontaktelementes entspricht. Bei diesem Ausgleichselement 28 handelt es sich um ein elastisches und selektiv leitfähiges Medium, das zwischen das Kontaktelement 7 und die Leiterplatte 1 gelegt wird, um Unebenheiten in der zu prüfenden Leiterplattenstruktur auszugleichen und zu gewährleisten, daß alle Kontaktflächen a, b, c, ... einen sicheren Kontakt zu dem Kontaktelement 7 haben. Solche elastischen Medien müssen einerseits einen guten elektrischen Kontakt zu der halbleitenden Beschichtung 9 des Kontaktelementes 7 aufweisen und andererseits eine elastische Funktion besitzen, ohne jedoch alle Kontaktflächen a, b, c, ... kurzzuschließen. Zur Erfüllung dieser Anforderungen sind verschiedene Technologien bekannt und können je nach Anforderungsprofil, d.h. je nach zu prüfenden Leiterplattenstrukturen und deren Oberflächenbeschaffenheit, eingesetzt werden.

In einem speziellen Ausführungsbeispiel werden dabei sogenannte Druck-Leitfähige-Gummimatten (PCR - Pressure Conductive Rubber), wie beispielsweise JSR 1000 und JSR 2000 der Firma Japan Synthetic Rubber Co., LTD., Tokio, Japan, eingesetzt. Dies sind anisotrop leitfähige Gummimatten, die mit gut elektrisch leitenden Kügelchen gefüllt sind und bei örtlicher Druckbeaufschlagung, d.h. örtlich begrenzter Komprimierung, in exakt diesem Bereich in z-Richtung, d.h. in der zu den Prüfstiften 10 parallelen Richtung, elektrisch leitend werden und zu den angrenzenden Bereichen die elektrische Isolation aufrecht erhalten bzw. entsprechend hochohmig sind. Solche Matten stehen in Dicken von wenigen 0,10mm zur Verfügung und können auf die Kontaktelement-Geometrien aufgebracht werden, wobei sie im allgemeinen durch Adhäsion auf der halbleitenden Beschichtung 9 haften bleiben.

In einer weiteren Ausführungsform können sogenannte elastomere Kontaktelemente 28. wie sie bei der Kontaktierung von LCD's und Leiterplatten bzw. allgemein zur Verbindung elektronischer Bauteileeingesetzt werden, verwendet werden. Dabei sind bei sehr unterschiedlichen Aufbauten üblicherweise höhere Aufbauabmessungen, im allgemeinen größer 1 mm, vorgesehen. Derartige Elastomer-Verbinder 28 können mit sehr dünnen in z-Richtung, d.h. in der zu den Prüfstiften 10 parallelen Richtung, ausgerichteten elektrisch leitenden Drähtchen oder anderen leitenden Strukturen gefüllt sein, die gegeneinander gut isoliert sind und nur über ihre Stirnflächen einen elektrischen Kontakt herstellen können. Alternativ können sie auch schichtartig aus elektrisch leitenden und isolierenden Schichten aufgebaut oder nur an ihrer Außenseite mit elektrisch leitenden extrem dünnen Beschichtungsstrukturen versehen sein, die ebenfalls nur eine örtlich begrenzte Verbindung in z-Richtung herstellen können. Solche Folien sind beispielsweise von der Firma FUJI Polymer Industries bzw. FUJIPOLY als ZEBRA oder MATRIX Elastomeric Connectors und dergleichen erhältlich.

Figur 5 zeigt einen vergrößerten Ausschnitt aus Figur 4, in dem deutlich die Wirkungsweise des druckleitenden Ausgleichselementes 28 zu erkennen ist. In den Bereichen der Kontaktflächen a, b, c, ... der ultrafeinen Leiterplattenstruktur wird das Ausgleichselement 28 in z-Richtung komprimiert und dadurch in diesen Bereichen in z-Richtung leitend. In den zwischen den Kontaktflächen a, b, c, ... liegenden Bereichen wird das Ausgleichselement 28 entsprechend nicht komprimiert und bleibt dort demzufolge elektrisch isolierend.

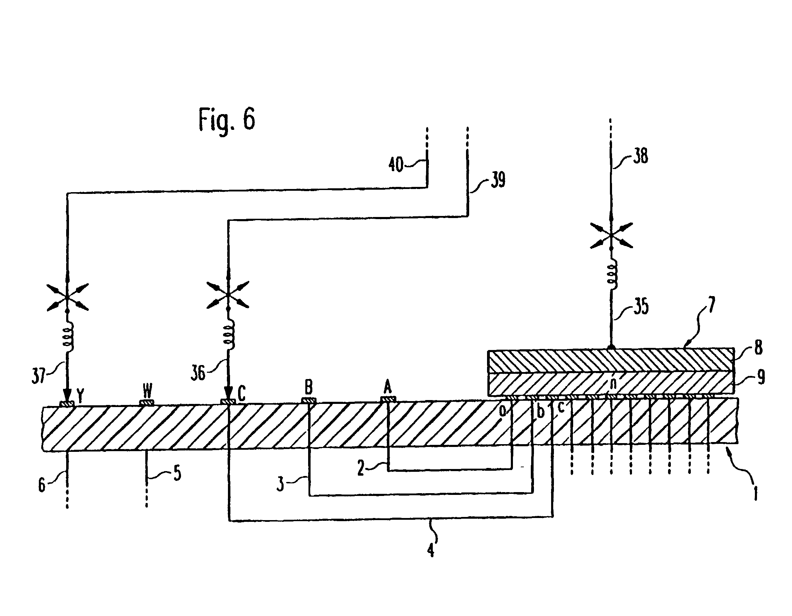

In Figur 6 ist schematisch die Anwendung eines Kontaktelementes 7 gemäß der vorliegenden Erfindung in einem fliegenden Prüffinger-System dargestellt. Der Einfachheit halber ist hier nur ein Kontaktelement 7 ohne Ausgleichselement 28 gezeigt, und es wurde auf die Darstellung der Auswerte- und Steuer-Elektronik verzichtet, die prinzipiell der in den Figuren 2 und 3 beschriebenen entspricht.

Das fliegende Prüffinger-System enthält drei Prüfstifte 35-37 mit eingebauten Federn, die in allen Richtungen frei beweglich über die Leiterplatte 1 führbar sind. Einer der Prüfstifte 35 ist fest mit dem Kontaktelement 7 verbunden, welches somit ebenfalls frei beweglich über die Leiterplatte 1 bewegt werden kann. Für die Ansteuerung der beliebig wählbaren Prüfpositionen ist ein entsprechend optimiertes Softwareprogramm notwendig. Die Prüfung der Leiterplatte 1 auf Unterbrechung oder Isolation der Leiterbahnen 2-6 bzw. der mit diesen verbundenen Kontaktflächen a, b, c, ..., A, B, C, ..., W, X, Y, Z erfolgt analog der obigen Beschreibung anhand der Figuren 2 und 3, die für einen Fachmann aufgrund der obigen Beschreibung ohne weiteres ersichtlich ist.

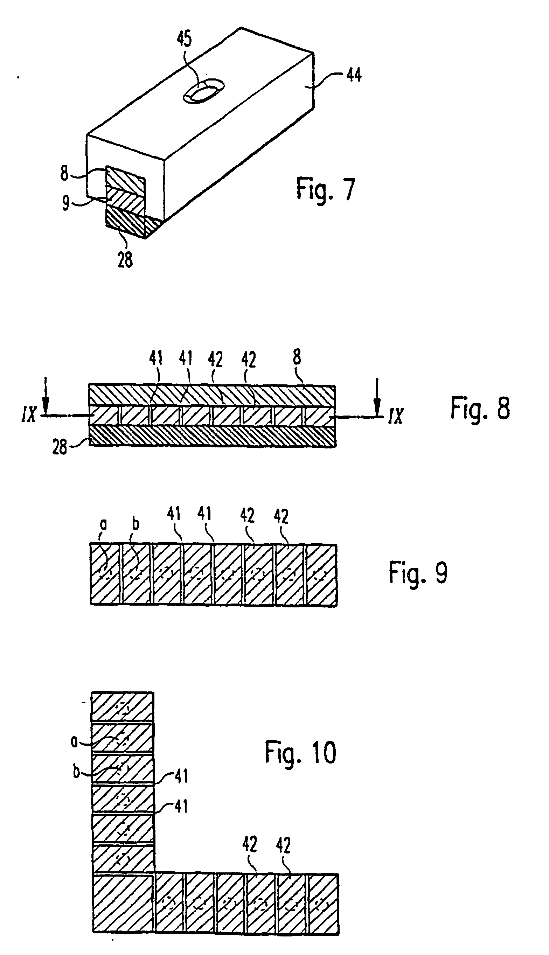

Figur 7 zeigt in perspektivischer Ansicht den schematischen Aufbau eines weiteren Ausführungsbeispieles eines Kontaktelementes 7. Um die Handhabbarkeit eines oben beschriebenen Kontaktelementes 7 zu erhöhen, ist das hier gezeigt Kontaktelement 7 auf seiner den Prüfstiften 10 zugewandten Seite mit einem Führungselement 44 eingefasst. Das Führungselement 44 besteht dabei aus einem elektrisch isolierenden Material und bedeckt die den Prüfstiften 10 zugewandte Seite und zumindest teiweise wenigstens einige der Seitenflächen des Kontaktelementes 7. Wegen der einfacheren Konstruktion des Führungselementes 44 sind in dem hier gezeigten Ausführüngsbeispiel die beiden Stirnseiten des Kontaktelementes 7 nicht von dem Führungselement 44 eingefasst, das Führungselement im wesentlichen in der Form eines U-Profils ausgebildet. Das Führungselement 44 darf sich nur soweit über die Seitenflächen des Kontaktelements 7 nach unten erstrecken, daß die Funktionsfähigkeit des Kontaktelementes 7 nicht beeinrächtigt wird. Insbesondere muß dabei die Kompression eines evt. vorhandenen Ausgleichselementes 28 berücksichtigt werden. An der den Prüfstiften 10 zugewandten Seite des Führungselementes 44 weist dieses zumindest eine Aussparung 45 auf, die derart bemessen ist, daß ein Prüfstift 10 durch sie hindurch das Kontaktelement 7 sicher kontaktieren kann.

Ein weiteres Ausführungsbeispiel eines Kontaktelementes 7 ist in Figur 8 im Schnitt entlang seiner Längsachse dargestellt. Die der Leiterplatte 1 zugewandte Seite des Kontaktelementes 7 ist nicht vollflächig mit einer halbleitenden Beschichtung versehen, sondern weist in diesem Ausführungsbeispiel Flächenelemente 42 aus einem halbleitenden Material auf, wobei die zwischen den halbleitenden Flächenelementen 42 liegenden Bereiche 41 isolierend ausgeführt sind. Die Zwischenbereiche 41 können dabei entweder aus einem isolierenden Material oder durch Aussparungen zwischen den halbleitenden Flächenelementen 42 gebildet werden.

Die halbleitenden Flächenelemente 42 können sowohl streifenförmig ausgebildet sein, wobei zumindest fünf solcher Streifen 42 je 0,1 mm Kantenlänge des Kontaktelementes 7 vorgesehen werden, oder matrixförmig angeordnet sein, wobei zumindest fünf solcher Flächenelemente 42 auf einer Fläche von 0,1 mm x 0,1 mm des Kontaktelementes 7 vorgesehen werden.

Die Figuren 9 bis 11 zeigen verschiedene mögliche geometrische Konfigurationen der Kontaktelemente 7, wobei die Kontaktelemente 7 jeweils im Schnitt entlang Linie IX-IX von Figur 8 dargestellt sind. Prinzipiell sind die Kontaktelemente 7 in beliebiger Geometrie herstellbar und einsetzbar. In der einfachsten Form werden, wie in Figur 9 gezeigt, Streifen von etwa 1 bis 2 mm Breite auf die jeweils notwendige Länge gebracht und dann in die jeweiligen Prüfadapter eingesetzt. Entsprechend der Geometrie der zu prüfenden Leiterplattenstruktur können vorzugsweise auch L-, U-, quadratische oder rechteckige Geometrien sowie Kombinationen davon verwendet werden, wie dies in den Figuren 10 und 11 angedeutet ist. Die geometrische Konfiguration des in Figur 11 gezeigten Ausführungsbeispieles, d.h. die rahmenförmige Grundfläche des Kontaktelementes 7 ist insbesondere für die Prüfung eines IC-Bausteines mit elektrischen Kontakten an allen vier Seiten geeignet. Die Wahl der speziellen Ausführungsform wird unter anderem die Kosten der Kontaktelemente und deren Lagerlogistik, sowie durch ihre Handhabbarkeit und einfache Einsetzbarkeit in die Prüfadapter bestimmt.

In den Figuren 9 bis 11 sind zusätzlich die Kontaktflächen a, b, ... der zu prüfenden ultrafeinen Leiterplattenstruktur angedeutet. Die Figuren veranschaulichen das Prinzip, daß die halbleitenden Flächenelemente 42 jeweils über einer der Kontaktflächen a, b, ... zu liegen kommen und die Kontaktflächen a, b, ... durch die Aussparungen bzw. die isolierenden Bereiche 41 zwischen den halbleitenden Flächenelementen 42 des Kontaktelementes 7 gegeneinander isoliert sind. Diese Maßnahme verbessert gegenüber einer oben beschriebenen vollflächigen halbleitenden Beschichtung 9 die Isolation der Kontaktflächen gegeneinander, wobei aber der Vorteil des gemeinsamen elektrischen Anschlusses 8 beibehalten wird.

Figur 12 zeigt die Funktionsfähigkeit einer mit einem oben anhand verschiedener Ausführungsbeispiele beschriebenen Kontaktelement 7 ausgestatteten Leiterplattenprüfvorrichtung. Die erfindungsgemäße Vorrichtung ist in der Lage, eine ultrafeine Leiterplattenstruktur, wie sie in Figur 12 etwa im Maßstab 2:1 dargestellt ist, zu prüfen. Die ultrafeine Leiterplattenstruktur enthält auf einer Fläche von etwa 1 Inch x 1 Inch ungefähr 16 x 16 Kontaktflächen, d.h. das Rastermaß der einzelnen Kontaktflächen beträgt weniger als 1,5 mm.

## Patentansprüche

1. Vorrichtung zum Prüfen der Leiterbahnen (2-6) von elektrischen Leiterplatten (1) auf Unterbrechung oder Isolation, mit Prüfstiften (10-15; 35-37) zum Kontaktieren der Leiterbahnen (2-6) bzw. der mit diesen verbundenen Kontaktflächen (a, b, c, ...; A, B, C, ...; X, Y, Z), mit einer mit den Prüfstiften verbindbaren Prüfspannungsquelle (16) und mit einer Auswerteschaltung (26), die den Stromfluß durch die mit der Prüfspannungsquelle einerseits und der (den) zu prüfenden Leiterbahn(en) andererse its verbundenen Prüfstiften als Fehlerprüfergebnis auswertet,
wobei ein zwischen wenigstens einem Prüfstift (10; 35) und die Leiterplatte (1) einrührbares Kontaktelement (7) vorgesehen ist, dessen dem Prüfstift zugewandte Seite aus leitendem Material (8) besteht und mit mindestens einem Prüfstift (10; 35) eine elektrische Kontaktverbindung bilden kann,
die der Leiterplatte zugewandte Seite des Kontaktelementes (7) Abmessungen derart hat, dass das Kontaktelement zur gleichzeitigen Kontaktierung von mindestens zwei Leiterbahnen (2-4) oder Kontaktflächen (a, b, c..) geeignet ist,
und das Kontaktelement (7) zwischen einem Durchlassmodus und einem Sperrmodus umschaltbar ist, wobei es im Durchlassmodus einen Stromfluss zwischen dem (den) entsprechenden Prüfstift(en) und den kontaktierten Leiterbahnen oder Kontaktflächen zulässt und im Sperrmodus einen solchen Stromfluss unterbindet und zusätzlich die kontaktierten Leiterbahnen oder Kontaktflächen voneinander isoliert.

2. Vorrichtung nach Anspruch 1,
**dadurch gekennzeichnet,**
**dass** das Material (8) der den Prüfstiften (10; 35) zugewandte Seite des Kontaktelementes (7) ein Metall ist.

3. Vorrichtung nach Anspruch 1 oder 2,
**dadurch gekennzeichnet,**
**dass** die der Leiterplatte zugewandte Seite des Konaktelementes (7) mit einer Beschichtung (9) aus einem Halbleitermaterial versehen ist, und
eine Vorspannungsquelle (16) vorgesehen ist, um im Sperrmodus eine Vorspannung zwischen der den Prüfstiften zugewandten Seite (8) und der der Leiterplatte zugewandten Beschichtung (9) des Kontaktelementes (7) anzulegen, die den Stromfluß zwischen dem (den) entsprechenden Prüfstift(en) und den kontaktierten Leiterbahnen oder Kontaktflächen unterbindet.

4. Vorrichtung nach einem der Ansprüche 1 bis 3,
**dadurch gekennzeichnet, daß**
bei Verwendung eines Prüfadapters dieser auf seiner der Leiterplatte (1) zugewandten Seite mit einer Ausnehmung (43) zur teilweisen oder vollständigen Aufnahme des Kontaktelementes (7) versehen ist.

5. Vorrichtung nach einem der Ansprüche 1 bis 3,
**dadurch gekennzeichnet, daß**
bei Verwendung eines Mehrplatten-Prüfadapters die der Leiterplatte (1) nächstliegende Führungsplatte (33) des Prüfadapters mit einer Ausnehmung (43) zur teilweisen oder vollständigen Aufnahme des Kontaktelementes (7) versehen ist.

6. Vorrichtung nach einem der Ansprüche 1 bis 3,
**dadurch gekennzeichnet, daß**
bei Verwendung eines fliegenden Prüffinger-Systems zumindest einer der Prüfstifte (35) fest mit dem Kontaktelement (7) verbunden ist.

7. Vorrichtung nach einem der vorhergehenden Ansprüche,
**dadurch gekennzeichnet, daß**
die der Leiterplatte zugewandte Seite des Kontaktelementes (7) Flächenelemente (42) aus halbleitendem Material aufweist, wobei die Flächenelemente (42) matrixförmig angeordnet und die zwischen den beschichteten Flächenelementen (42) liegenden Bereiche (41) isolierend ausgeführt sind.

8. Vorrichtung nach einem der vorhergehenden Ansprüche,
**dadurch gekennzeichnet, daß**
die der Leiterplatte zugewandte Seite des Kontaktelementes (7) streifenförmige Flächenelemente (42) aus halbleitendem Material (9) aufweist, wobei die zwischen den beschichteten Flächenelementen (42) liegenden Bereiche (41) isolierend ausgeführt sind.

9. Vorrichtung nach einem der vorhergehenden Ansprüche,
**dadurch gekennzeichnet, daß**
auf die der Leiterplatte (1) zugewandten Seite des Kontaktelementes (7) ein druckleitendes Ausgleichselement (28) aufgebracht ist, das elastisch und selektiv unter Druckeinwirkung elektrisch leitend und ohne Druckeinwirkung isolierend ist.

10. Vorrichtung nach Anspruch 9,
**dadurch gekennzeichnet, daß**
das Ausgleichselement (28) eine anisotrop leitfähige Gummimatte ist, die mit gut elektrisch leitenden Kügelchen gefüllt ist.

11. Vorrichtung nach Anspruch 9,
**dadurch gekennzeichnet, daß**
das Ausgleichselement (28) eine elastomere Matte ist, die mit sehr dünnen gut elektrisch leitenden Drähtchen oder leitenden Strukturen gefüllt ist, die gegeneinander elektrisch isoliert und in der zu den Prüfstiften (10) parallelen Richtung ausgerichtet sind.

12. Vorrichtung nach einem der vorhergehenden Ansprüche,
**dadurch gekennzeichnet, daß**
die Prüf- und Vorspannungsquelle (16) Meßspannungen und -ströme ausgibt.

13. Vorrichtung nach einem der vorhergehenden Ansprüche,
**dadurch gekennzeichnet, daß**
die geometrische Grundfläche des Kontaktelementes (7) streifenförmig, L-förmig, U-förmig oder rechteckförmig und flächenförmig oder rahmenförmig ist.

14. Vorrichtung nach einem der vorhergehenden Ansprüche,
**dadurch gekennzeichnet, daß**
ein Führungselement (44) aus isolierendem Material vorgesehen ist, welches das Kontaktelement (7) an der dem (den) Prüfstift(en) (10; 35) zugewandten Seite zumindest teilweise einfasst.

15. Vorrichtung nach Anspruch 14,
**dadurch gekennzeichnet, daß**
das Führungselement (44) an seiner dem (den) Prüfstift(en) (10; 35) zugewandten Seite eine Ausnehmung (45) aufweist, durch die hindurch der (die) Prüfstift(e) das Kontaktelement (7) kontaktieren kann (können).

16. Vorrichtung nach einem der Ansprüche 2 bis 15,
**dadurch gekennzeichnet, daß**
das Material (8) der den Prüfstiften zugewandte Seite des Kontaktelementes (7) eines aus der Gruppe Messing, Nirosta, Wolfram und oberflächen-vergoldetes Metall ist.

## Claims

1. Apparatus for testing the conductor tracks (2-6) of electrical circuit boards (1) for open circuit or isolation, having test pins (10-15; 35-37) for contacting the conductor tracks (2-6) or the contact areas (a, b, c, ... ; A, B, C, ... ; X, Y, Z) connected to the latter, having a test-voltage source (16) that can be connected to the test pins and having an evaluation circuit (26) that evaluates the current flow through the test pins connected to the test-voltage source, on the one hand, and to the conductor track(s) to be tested, on the other hand, as a fault test result, wherein a contact element (7) is provided that can be introduced between at least one test pin (10; 35) and the circuit board (1) and whose side adjacent to the test pin is composed of conducting material (8) and can form an electrical contact connection with at least one test pin (10; 35),
that side of the contact element (7) adjacent to the circuit board has dimensions such that the contact element is suitable for the simultaneous contacting of at least two conductor tracks (2-4) or contact areas (a, b, c ...),
and the contact element (7) can be switched over between a conducting mode and a nonconducting mode, wherein it permits, in the conducting mode, a current flow between the corresponding test pin(s) and the contacted conductor tracks or contact areas and, in the nonconducting mode, suppresses such a current flow and, in addition, insulates the contacted conductor tracks or contact areas from one another.

2. Apparatus according to Claim 1, **characterized in that** the material (8) of that side of the contact element (7) adjacent to the test pins (10; 35) is a metal.

3. Apparatus according to Claim 1 or 2, **characterized in that** that side of the contact element (7) adjacent to the circuit board is provided with a coating (9) made of a semiconductor material and a bias source (16) is provided in order to apply a bias in the conducting mode between the side (8) adjacent to the test pins and the coating (9), adjacent to the circuit board, of the contact element 7, which bias suppresses the current flow between the corresponding test pin(s) and the contacted conductor tracks or contact areas.

4. Apparatus according to one of Claims 1 to 3, **characterized in that**, if a test adapter is used, it is provided on its side adjacent to the circuit board (1) with a recess (43) for the partial or complete reception of the contact element (7).

5. Apparatus according to one of Claims 1 to 3, **characterized in that**, if a multiple-plate test adapter is used, that guide plate (33) of the test adapter nearest the circuit board (1) is provided with a recess (43) for the partial or complete reception of the contact element (7).

6. Apparatus according to one of Claims 1 to 3, **characterized in that** if a flying test probe system is used, at least one of the test pins (35) is permanently connected to the contact element (7).

7. Apparatus according to one of the preceding claims, **characterized in that** that side of the contact element (7) adjacent to the circuit board has surface elements (42) made of semiconducting material, the surface elements (42) being disposed in the form of a matrix and the regions (41) situated between the coated surface elements (42) are of isolating design.

8. Apparatus according to one of the preceding claims, **characterized in that** that side of the contact element (7) adjacent to the circuit board has strip-shaped surface elements (42) made of semiconducting material (9), the regions (41) situated between the coated surface elements (42) being of isolating design.

9. Apparatus according to one of the preceding claims, **characterized in that** there is mounted on that side of the contact element (7) adjacent to the circuit board (1) a take-up element (28) that conducts under pressure and that is elastic and electrically conducting selectively under the action of pressure and is isolating without the action of pressure.

10. Apparatus according to Claim 9, **characterized in that** the take-up element (28) is an anisotropically conductive rubber mat that is filled with spherules having good electrical conduction.

11. Apparatus according to Claim 9, **characterized in that** the take-up element (28) is an elastomeric mat that is filled with very thin wires having good electrical conduction or conducting structures that are electrically isolated from one another and that are aligned in the direction parallel to the test pins (10).

12. Apparatus according to one of the preceding claims, **characterized in that** the test-voltage and bias source (16) emits measuring voltages and currents.

13. Apparatus according to one of the preceding claims, **characterized in that** the geometric base area of the contact element (7) is strip-shaped, L-shaped, U-shaped or rectangular and laminar or frame-shaped.

14. Apparatus according to one of the preceding claims, **characterized in that** a guide element (44) made of insulating material is provided that frames the contact element (7) at least partly at the side adjacent to the test pin(s) (10; 35).

15. Apparatus according to Claim 14, **characterized in that** the guide element (44) has, on its side adjacent to the test pin(s) (10; 35), a recess through which the test pin(s) can contact the contact element (7).

16. Apparatus according to one of Claims 2 to 15, **characterized in that** the material (8) of that side of the contact element (7) adjacent to the test pins is from the group comprising brass, Nirosta, tungsten and superficially gold-plated metal.

## Revendications

1. Dispositif pour tester les pistes conductives (2-6) de circuits imprimés électriques (1) pour la coupure ou l'isolation, avec des pointes de test (10-15 ; 35-37) pour la mise en contact des pistes conductives (2-6) ou des faces de contact reliées à celles-ci (a, b, c, ... ; A, B, C, ... ; X, Y, Z), avec une source de tension de test (16) pouvant être connectée aux pointes de test et avec un circuit d'évaluation (26) qui évalue le passage du courant par les pointes de test connectées, d'une part, à la source de tension de test et, d'autre part, à la ou aux piste(s) conductive(s) à tester, en tant que résultat de test d'erreur,
moyennant quoi un élément de contact (7) pouvant être introduit au moins entre une pointe de test (10 ; 35) et le circuit imprimé (1) est prévu et dont le côté en regard de la pointe de test consiste en un matériau conducteur (8) et peut former avec au moins une pointe de test (10 ; 35) une connexion de contact électrique,
le côté en regard du circuit imprimé de l'élément de contact (7) possède des dimensions telles que l'élément de contact est apte à venir simultanément en contact avec au moins deux pistes conductives (2-4) ou faces de contact (a, b, c...),
et l'élément de contact (7) peut être commuté entre un mode de passage et un mode de blocage, de telle sorte que dans le mode de passage on laisse passer un flux de courant entre la ou les pointe(s) de test correspondante(s) et les pistes conductives contactées ou les faces de contact, et en mode de blocage on interdit ce passage de courant et, de plus, on isole entre elles les pistes conductives contactées ou faces de contact.

2. Dispositif selon la revendication 1, **caractérisé en ce que**
le matériau (8) de la face en regard des pointes de test (10 ; 35) de l'élément de contact (7) est un métal.

3. Dispositif selon la revendication 1 ou 2, **caractérisé en ce que**
le côté en regard du circuit imprimé de l'élément de contact (7) est muni d'un revêtement (9) en un matériau semi-conducteur, et
il est prévu une source de pré-tension (16) pour appliquer dans le mode de blocage une pré-tension entre le côté en regard des pointes de test (8) et le revêtement (9) en regard du circuit imprimé, de l'élément de contact (7), qui interdit le passage de courant entre la ou les pointe(s) de test correspondante(s) et les pistes conductives contactées ou faces de contact.

4. Dispositif selon l'une des revendications 1 à 3, **caractérisé en ce que**
dans l'utilisation d'un adaptateur de test de ce côté en regard du circuit imprimé (1), il est prévu un évidement (43) pour le logement partiel ou total de l'élément de contact (7).

5. Dispositif selon l'une des revendications 1 à 3, **caractérisé en ce que**
dans l'utilisation d'un adaptateur de test à circuits multiples, la plaque de guidage (33) la plus proche du circuit (1), de l'adaptateur de test, est munie d'un évidement (43) pour loger partiellement ou totalement l'élément de contact (7).

6. Dispositif selon l'une des revendications 1 à 3, **caractérisé en ce que**
dans l'utilisation d'un système à doigt de test volant, au moins l'une des pointes de test (35) est raccordée solidement à l'élément de contact (7).

7. Dispositif selon l'une des revendications précédentes, **caractérisé en ce que** le côté en regard du circuit de l'élément de contact (7) présente des éléments de face (42) en matériau semi-conducteur, moyennant quoi les éléments de face (42) sont disposés en forme de matrice et les zones (41) situées entre les éléments à face revêtue (42) sont de conception isolante.

8. Dispositif selon l'une des revendications précédentes, **caractérisé en ce que**
le côté en regard du circuit, de l'élément de contact (7) présente des éléments de face (42) en forme de bande en matériau semi-conducteur (9), moyennant quoi les zones (41) situées entre les éléments de face revêtus (42) sont de conception isolante.

9. Dispositif selon l'une des revendications précédentes, **caractérisé en ce que**
sur le côté en regard du circuit (1) de l'élément de contact (7) est appliqué un élément de compensation (28) conducteur de tension qui est conducteur électriquement, élastiquement et sélectivement sous l'effet de la pression et est isolant en l'absence d'effet de la pression.

10. Dispositif selon la revendication 9, **caractérisé en ce que**
l'élément de compensation (28) est une plaque de caoutchouc conductrice anisotrope qui est remplie de billes conductrices électriquement.

11. Dispositif selon la revendication 9, **caractérisé en ce que**
l'élément de compensation (28) est une nappe élastomère qui est remplie de fils très fins conducteurs électriquement ou de structures conductrices qui sont isolées électriquement entre elles et sont dirigées dans la direction parallèle aux pointes de test (10).

12. Dispositif selon l'une des revendications précédentes, **caractérisé en ce que**
la source de pré-tension et de tension de test (16) donne des intensités et des tensions de mesure.

13. Dispositif selon l'une des revendications précédentes, **caractérisé en ce que**
la face de base géométrique de l'élément de contact (7) est en forme de bande, en forme de L, en forme de U ou en forme de rectangle ou plane ou en forme de châssis.

14. Dispositif selon l'une des revendications précédentes, **caractérisé en ce que**
il est prévu un élément de guidage (44) en matériau isolant qui enrobe l'élément de contact (7) sur le côté en regard du ou des pointe(s) de test (10 ; 35) au moins partiellement.

15. Dispositif selon la revendication 14, **caractérisé en ce que**
l'élément de guidage (44) présente un évidement (45) sur le côté en regard de la ou des pointe(s) de test (10 ; 35) à travers lequel la ou les pointe(s) peuvent venir en contact avec l'élément de contact (7).

16. Dispositif selon l'une des revendications 2 à 15, **caractérisé en ce que**
le matériau (8) du côté en regard des pointes de test de l'élément de contact (7) est un métal du groupe laiton, nirosta, tungstène et métal plaqué or.
